# EUROPEAN PATENT SPECIFICATION

(11) **EP 4 081 816 B1**
(45) Date of publication and mention of the grant of the patent: **21.02.2024**
(21) Application number: 20842313.7
(22) Date of filing: 23.12.2020
(51) Int. Cl.: G01R 21/133, G01R 22/10, H02J 3/00, G01D 4/00, G01R 19/25

(54) **A METHOD, DEVICE AND SYSTEM FOR THE AUTONOMOUS MAPPING OF AN ENERGY METER**
VERFAHREN, VORRICHTUNG UND SYSTEM ZUR AUTONOMEN ABBILDUNG EINES ENERGIEZÄHLERS
PROCÉDÉ, DISPOSITIF ET SYSTÈME POUR LA CARTOGRAPHIE AUTONOME D'UN COMPTEUR D'ENERGIE

(30) Priority: 23.12.2019 PT 2019116015; 27.12.2019 EP 19219937
(43) Date of publication of application: 02.11.2022
(73) Proprietor: Eneida Grid Intelligence, S.A., 3000-019 Coimbra (PT)
(72) Inventor: GALHARDO, Bruno, 3030-199 Coimbra (PT); CERQUEIRA, Tiago, 3030-199 Coimbra (PT)
(74) Representative: do Nascimento Gomes, Rui
(86) International application number: PCT/IB2020/062413
(87) International publication number: WO 2021/130706

(56) References cited:
- US-A1- 2010 007 219
- US-A1- 2016 109 491
- US-A1- 2019 041 436
- US-A1- 2019 041 445

## Description

### FIELD OF THE INVENTION

The present invention is enclosed in the area of intelligent monitoring and control of the grid topology of a power distribution network.

### PRIOR ART

Today, the knowledge of the grid topology is reliant on the manual mapping of energy meters.

An installation/maintenance operator, with a specific device, injects a known pulse at the meter location, and the same signal is detected at one feeder/phase location at the transformer, thus giving its connection topology.

The main problem of these approaches is that they cannot keep up with several changes that occur in the network over time. Households can change feeder or phase without the knowledge of the operator, lines can be connected to other transformers without keeping track, among others. For blocks with no prior knowledge the operator needs to physically consult the device in question, and in some cases enter the household to do the mapping. Even still, such mapping methodology is not only cumbersome but also unreliable.

Some automatic solutions use only the energy (smart) meter data, as well as an assignment of a specific probable connection between such smart meter and a transformer and corresponding feeder.

Furthermore, even if correlations are performed between smart meters, there are limitations due to the number of accessible parameters. One can make correlations between the smart meters signals but this type of clustering is prone to be dependent of the model parameters and initial conditions.

Such is the case of the article of Seal, B.K., et al, "Automatic identification of service phase for electric utility customers", 2011 IEEE Power and Energy Society General Meeting.

US 2016/109491 discloses a method which involves obtaining voltage values from a metering node and a transformer, correlating such values and determining if the node is connected to the transformer.

Other approaches known in the art try to add additional variables such as GPS information of the meters. One of the problems is that this information is very sensitive and in some cases the operator is reluctant to provide. It is also prone to errors since the installers are responsible to log the coordinates and in some cases forget to add, or add several at some other location. Finally, it also makes assumptions on the topology and in the end households belonging to the same feeder can be uncorrelated to proximity.

Therefore, it becomes necessary to automatically map existing networks and periodically assert if there was a change in the known topology. It is therefore key to reliably know which substation (which has at least one associated transformer), corresponding feeder line and phase to which an energy smart meter is connected to, an improvement provided by the present invention.

### SUMMARY OF THE INVENTION

It is therefore an object of the present invention method for the autonomous mapping of an energy meter which comprises the following steps:
i) obtaining at least one signal from a power transformer,
ii) obtaining at least one signal from an energy meter,
iii) correlating the at least one signal from the power transformer with the at least one signal from an energy meter, thereby obtaining a correlation value, and
iv) based on the correlation value, determining if said energy meter is connected to a branch fed by said power transformer,
wherein the at least one signal from a power transformer comprises a signal obtained from a feeder of the power transformer, and step iv) provides the determination of whether said energy meter is connected to a branch fed by said feeder of the power transformer, and wherein the correlation of step iii) specifically comprises:
- determining a load of said transformer and logically associating more than one energy meter to said load,
- summing the signals from said more than one energy meters, and
- logically matching said sum to the transformer load, wherein the correlation value is obtained from said matching.

The method of the present invention thereby provides the autonomous mapping of energy meters by feeder and, as a consequence, also of the household or other kind of installation which such energy meter monitors. Such energy meters are commonly referred to as smart meters. The provision of one or more sensors in a transformer substation, which corresponds to the obtaining of at least one signal from such power transformer, allows to achieve an automated methodology-in otherwords, a methodology implemented or implementable by a computational device -, available to be implemented by a device which provides an indication of the branch to which the energy meter is connected. It therefore allows to promptly identify the transformer and branch of the feeder to which the energy meter is connected from the signals of both such meter and transformer. Optionally, each signal from each energy meter comprises active power series data from such meter, which thereby allows to sum such values and obtain a result comparable (able to be matched) to the determined transformer load. Such procedure may be designated aggregation of meters. Preferably, said logical matching is performed at a monophasic level, and subsequently at a three-phasic level. The logical association / assignment performed between the more than one energy meters and the load is a logical assignment or association, as it is implemented by the automated method of the invention. In addition, a matching may also be referred to as a comparison between the sum of the signals from said sum of signals of more than one energy meters and the determined transformer load. The measure of such matching/comparison results in the correlation value, which allows to determine how close or how far the two values are, and thereby provide an indication of the branch to which the more than one energy meters are connected. The term power series data corresponds to the usage of sampled measures.

In an embodiment, the method comprises the determination of a load specifically comprises determining active power series data from the transformer, the correlation active power series data of the power transformer with active power series data from the more than one energy meters.

Such solution therefore directly allows to, for a transformer substation, determine which installations - which may consist of households - are connected to which of its branches. It therefore provides the determination of the load in each branch, and a reliable determination and planning of the connections to the branches of the substation, which simply is not possible by the solutions known in the art.

It is also an object of the present invention a device for the autonomous mapping of an energy meter wherein it comprises computing means, said computing means being configured to implement the method of the present invention, in any of its embodiments. Such device may be provided locally, close to the transformer substation, or remotely, where it receives the signals from each energy meter and each transformer, corresponding feeder and/or corresponding phase. The device comprises means for obtaining at least one signal from a power transformer and for obtaining at least one signal from an energy meter.

Furthermore, it is an object of the present invention a system for the device for the autonomous mapping of an energy meter wherein it further comprises the device of the present invention and the referred energy meter, the energy meter being configured to remotely transmit said at least one signal to the device. Such system may further comprise a power transformer sensor configured to acquire said at least one signal from a power transformer, the power transformer sensor being configured to remotely transmit said at least one signal to the device. As referred, preferably the system comprises a plurality of power transformer sensors and energy meters. The referred remote transmission of signals to the device may be provided by means of a wireless communication protocol.

### DESCRIPTION OF FIGURES

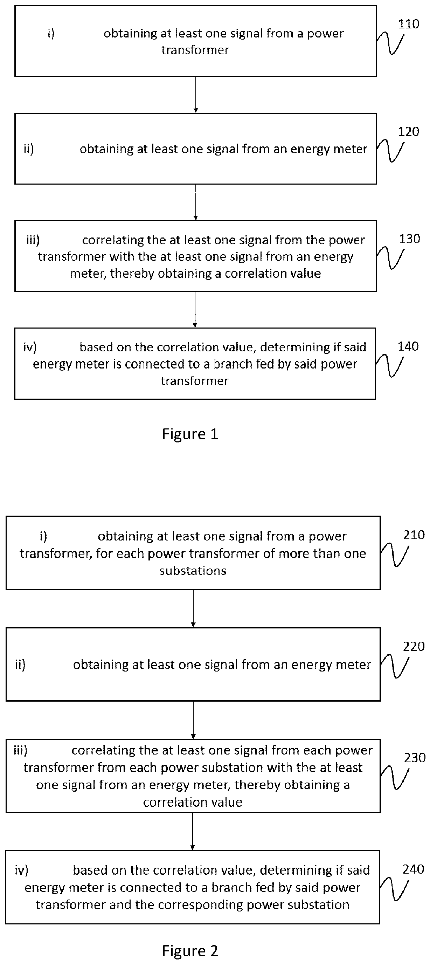

Figure 1 - representation of an embodiment of the method of the present invention, comprising the steps of i) obtaining at least one signal from a power transformer (110), ii) obtaining at least one signal from an energy meter (120), iii) correlating the at least one signal from the power transformer with the at least one signal from an energy meter, thereby obtaining a correlation value (130), and iv) based on the correlation value, determining if said energy meter is connected to a branch fed by said power transformer (140).
Figure 2 - representation of another embodiment of the method of the present invention, similar to the method of Figure 1 but in which it is expected that the energy meter may be connected to more than one power substation. Is such case, i) at least one signal from each power transformer of said more than one power substations (210), ii) at least one signal from an energy meter is obtained (220), iii) the at least one signal from each power transformer is correlated with the at least one signal from an energy meter, thereby obtaining a correlation value for each power transformer (230), and iv) based on the correlation values, determining if said energy meter is connected to a branch fed by said power transformer (240), and determining the respective power substation as well.

### DETAILED DESCRIPTION

The more general and advantageous configurations of the present invention are described in the Summary of the invention. Such configurations are detailed below in accordance with other advantageous and/or preferred embodiments of implementation of the present invention.

In an inventive aspect of the method of the present invention, the at least one signal from a power transformer further comprises a signal obtained from a phase of such power transformer, wherein step iv) provides the determination of whether said energy meter is connected to a branch fed by said feeder and phase of the power transformer. It therefore provides a more detailed determination, by correlating with a phase of the power transformer. Preferably, the signal of the energy meter further comprises a voltage signal and the signal obtained from a phase of such power transformer also comprises a voltage signal.

In another inventive aspect of the method of the present invention, the at least one signal from a power transformer includes both a signal obtained from a feeder and from a phase of the power transformer, wherein step iv) provides the determination of whether said energy meter is connected to a branch fed by said feeder and a branch fed by said phase of the power transformer. It therefore provides an even more detailed determination, by correlating with a feeder and respective phase of the power transformer.

In another inventive aspect of the method of the present invention, said correlation of step iii) specifically comprises a correlation between three signals corresponding to each phase and the at least one signal from an energy meter, step iv) providing the determination of whether said energy meter is connected to a branch fed by said phase of the power transformer.

Specifically, the method of the present invention may further comprise, upon the determination of the branch fed by a feeder and of the branch fed by a phase of the power transformer to which a subsequent energy meter is connected and upon determination that the subsequent energy meter has a null active power series data:
- logically associating such energy meter with at least one other energy meter which was determined to be connected in a same branch fed a feeder and phase of the power transformer, and
- correlating the at least one signal from the energy meter with the at least one signal from the other energy meter, obtaining the correlation value, and
thereby determining the correlation value, of whether said subsequent energy meter is connected to the same branch fed by said feeder and phase of the power transformer, to which the other energy meter was determined to be connected. In the context of the present feature, the referred logical association corresponds to the matching of an (subsequent) energy meter with another energy meter which was determined to be connected in a same branch fed a feeder and phase of the power transformer.

It therefore allows to determine the branch to which a (subsequent) meter is connected even in the case that the referred active power series data is null.

In a preferred embodiment of the method of the present invention, it is implemented with a plurality of energy meters, the determination of the branch being implemented for each of such energy meters. For a case of a specific energy meter, the correlation of the at least one signal from such energy meter is made with a plurality of signals from a plurality of other energy meters, and the correlation value is obtained from the other energy meter providing the highest correlation with the at least one signal from the energy meter.

Preferably, said at least one signal from a power transformer and said at least one signal from an energy meter consist of voltage signals.

Preferably, a sampling frequency of each of said signals-the signals being sampled - is within the range of 3-20 minutes, preferably 5-15, more preferably 5 minutes.

In a particular embodiment of the method of the present invention, where it is expected that an energy meter may be connected to more than one power substation, the correlation is performed between such energy meter and information from such more than one power substation (which may contain more than one power transformer, each providing said at least one signal from a power transformer). Thus, the correlation of the method of the present invention is performed between each energy meter and each power transformer (or respective components), which may relate to different substations. In such case, the substation to which the energy meter is connected, and which corresponds to such determined power transformer, is also determined. Such is the case of the method of Figure 2.

A specific embodiment of the method of the present invention is described subsequently.

The method comprises two sequential steps.

The first is to identify the transformer and feeder/phase of the meter from the voltage signals of both a meter and a sensor at the transformer level. An individual voltage signal of the meter is compared to three signals measured by the referred sensor at the transformer level, and a match is found for the highest correlation between the comparisons (three, in the case of one transformer, 3n for n transformers). Smart energy meters tested had a sampling frequency of 15 minutes and transformer measurements had samplings of 5 minutes and 15 minutes. In both cases high accuracies were achieved.

A second step includes matching the energy meter to the feeder using measurements taken at feeder level. In such case, a classification with a branch is attempted to energy meters to which a transformer and feeder/phase were assigned from the previous step. From the several implemented tests, less than 1 % of the energy meters fail the previous step, usually due to some problem at the meter.

In such case, active power series of the meter and the transformer individual feeders are compared and an iterative process starts to assign and sum the individual meters to match the transformer load. This is done at a monophasic level, then a tri-phasic level. In the end the remaining meters (even those with zero active power) are matched with other meters of the same phase and the ones with highest correlation are assigned the same feeder.

The method of the present invention may implement known correlation methodologies known in the art. In a particular implementation, correlation coefficients are calculated between voltage signal series and between power series obtained from each energy meter. A measure of the correlation may be provided by a determination that higher these coefficients, the greater the similarity between the signals, and thereby the better the determination of the correlation.

In particular, the method of the present invention may provide enhanced results where, for phase mapping, voltage series of each phase of each smart meter is correlated with phases of each transformer, such transformer(s) preferably consisting of transformer(s) to which a connection is expected.

In particular, the method of the present invention may provide enhanced results where, for feeder mapping, active power series of each smart meter is correlated with the different transformer series (identified those obtained during phase mapping) of active power per feeder / phase.

Preferably, voltage and active power of smart meters is acquired by the smart meter itself and made available to the method and system of the present invention automatically or by an operator intervention.

In addition, voltage at transformer level may be provided by the transformer itself or by an external sensor. Active power may be provided by an external sensor, measured at each feeder / phase individually, as the transformer itself measures only one aggregation across all lines / phase.

As will be clear to one skilled in the art, the present invention should not be limited to the embodiments described herein, and a number of changes are possible which remain within the scope of the present invention as defined in the appended claims.

Of course, the preferred embodiments shown above are combinable, in the different possible forms, being herein avoided the repetition all such combinations.

## Claims

1. A method for the autonomous mapping of an energy meter which comprises the following steps:
i) obtaining at least one signal from a power transformer (110),
ii) obtaining at least one signal from an energy meter(120),
iii) correlating the at least one signal from the power transformer with the at least one signal from an energy meter, thereby obtaining a correlation value (130),
iv) based on the correlation value, determining if said energy meter is connected to a branch fed by said power transformer (140), and
is **characterised in that** the at least one signal from a power transformer comprises a signal obtained from a feeder of the power transformer, and step iv) (140) provides the determination of whether said energy meter is connected to a branch fed by said feeder of the power transformer, and wherein the correlation of step iii) (130) specifically comprises:
- determining a load of said transformer and logically associating more than one energy meter to said load,
- summing the signals from said more than one energy meters, and
- logically matching said sum to the transformer load, wherein the correlation value is obtained from said matching.

2. A method according to the previous claim wherein the at least one signal from a power transformer further comprises a signal obtained from a phase of such power transformer, wherein step iv) (140) provides the determination of whether said energy meter is connected to a branch fed by said phase and feeder of the power transformer.

3. A method according to any of the preceding claims wherein each signal from each energy meter comprises active power series data from such meter.

4. A method according to the previous claim wherein the determination of a load specifically comprises determining active power series data from the transformer, the correlation active power series data of the power transformer with active power series data from the more than one energy meters.

5. A method according to the previous claim wherein said matching is performed at a monophasic level, and subsequently at a three-phasic level.

6. A method according to any of the claims 2-5 wherein said correlation of step iii) (130) specifically further comprises a correlation between three signals corresponding to each phase and the at least one signal from an energy meter, step iv) (140) providing the determination of whether said energy meter is connected to a branch fed by said phase of the power transformer.

7. A method according to any of the claims 2-5 and claim 6 wherein it further comprises, upon the determination of the branch fed by a feeder and of the branch fed by a phase of the power transformer to which a subsequent energy meter is connected and upon determination that such subsequent energy meter has a null active power series data:
- logically associating such energy meter with at least one other energy meter which was determined to be connected in a same branch fed a feeder and phase of the power transformer, and
- correlating the at least one signal from the subsequent energy meter with the at least one signal from the other energy meter, obtaining the correlation value, and
thereby determining the correlation value, of whether said subsequent energy meter is connected to the same branch fed by said feeder and phase of the power transformer, to which the other energy meter was determined to be connected.

8. A method according to the previous claim wherein the correlation the at least one signal from the energy meter is made with a plurality of signals from a plurality of other energy meters, and the correlation value is obtained from the other energy meter providing the highest correlation with the at least one signal from the energy meter.

9. A method according to any of the preceding claims wherein said at least one signal from a power transformer and said at least one signal from an energy meter consist of voltage signals.

10. A method according to any of the preceding claims wherein a sampling frequency of each of said signals is within the range of 3-20 minutes, preferably 5-15, more preferably 15 minutes.

11. A device for the autonomous mapping of an energy meter wherein it is configured to implement the method of any of the claims 1-10, the device comprising means for obtaining at least one signal from a power transformer (110) and for obtaining at least one signal from an energy meter.

12. A system for the device for the autonomous mapping of an energy meter wherein it further comprises the device according to the previous claim and the referred energy meter, the energy meter being configured to remotely transmit said at least one signal to the device.

13. A system according to the previous claim wherein it further comprises a power transformer sensor configured to acquire said at least one signal from a power transformer, the power transformer sensor being configured to remotely transmit said at least one signal to the device.

14. A system according to the previous claim wherein the system comprises a plurality of power transformer sensors and energy meters.

15. Non-transitory storage media including program instructions executable to carry out the method of any of the claims 1-10.

## Patentansprüche

1. Ein Verfahren zur autonomen Abbildung eines Energiezählers das folgende Schritte umfasst:
i) mindestens ein Signal von einem Leistungstransformator (110) zu erhalten,
ii) mindestens ein Signal von einem Energiezähler (120) zu erhalten,
iii) Korrelieren des mindestens einen Signals von dem Leistungstransformator mit dem mindestens einen Signal von einem Energiezähler, wodurch ein Korrelationswert (130) erhalten wird,
iv) auf der Grundlage des Korrelationswerts bestimmen, ob der Energiezähler an einen Zweig angeschlossen ist, der von dem Leistungstransformator (140) gespeist wird, und
**dadurch gekennzeichnet ist, dass** das mindestens eine Signal von einem Leistungstransformator ein Signal umfasst, das von einer Einspeisung des Leistungstransformators erhalten wird, und Schritt iv) (140) die Bestimmung bereitstellt, ob der Energiezähler mit einem Zweig verbunden ist, der von der Einspeisung des Leistungstransformators gespeist wird, und wobei die Korrelation von Schritt iii) (130) insbesondere umfasst:
- Bestimmung einer Last des Transformators und logische Zuordnung von mehr als einem Energiezähler zu dieser Last,
- Summierung der Signale von mehr als einem Energiezähler, und
- logische Anpassung der Summe an die Transformatorlast, wobei der Korrelationswert aus dieser Anpassung gewonnen wird.

2. Verfahren nach dem vorhergehenden Anspruch, wobei das mindestens eine Signal von einem Leistungstransformator ferner ein Signal umfasst, das von einer Phase eines solchen Leistungstransformators erhalten wird, wobei Schritt iv) (140) die Bestimmung bereitstellt, ob der Energiezähler an einen Zweig verbunden ist, der von der Phase und der Einspeisung des Leistungstransformators gespeist wird.

3. Verfahren nach einem der vorhergehenden Ansprüche, wobei jedes Signal von jedem Energiezähler Wirkleistungsreihendaten von diesem Zähler umfasst.

4. Verfahren nach dem vorhergehenden Anspruch, wobei die Bestimmung einer Last insbesondere die Bestimmung von Wirkleistungsreihendaten des Transformators umfasst, wobei die Wirkleistungsreihendaten des Leistungstransformators mit Wirkleistungsreihendaten der mehr als einen Energiezähler korreliert werden.

5. Verfahren nach dem vorhergehenden Anspruch, wobei der Anpassung auf einer einphasigen Ebene und anschließend auf einer dreiphasigen Ebene durchgeführt wird.

6. Verfahren nach einem der Ansprüche 2-5, wobei die Korrelation von Schritt iii) (130) insbesondere weiterhin eine Korrelation zwischen drei Signalen, die jeder Phase entsprechen, und dem mindestens einen Signal von einem Energiezähler umfasst, wobei Schritt iv) (140) die Bestimmung liefert, ob der Energiezähler an einen Zweig angeschlossen ist, der von der Phase des Leistungstransformators gespeist wird.

7. Verfahren nach einem der Ansprüche 2-5 und Anspruch 6, wobei es ferner umfasst, dass bei der Bestimmung des Zweigs, der von einer Einspeisung gespeist wird, und des Zweigs, der von einer Phase des Leistungstransformators gespeist wird, an den ein nachfolgender Energiezähler angeschlossen ist, und bei der Bestimmung, dass ein solcher nachfolgender Energiezähler Wirkleistungsreihendaten von Null aufweist:
- logisches Zuordnen eines solchen Energiezählers zu mindestens einem anderen Energiezähler, von dem festgestellt wurde, dass er in demselben Zweig angeschlossen ist, der eine Einspeisung und Phase des Leistungstransformators speist, und
- Korrelieren des mindestens einen Signals von dem nachfolgenden Energiezählers mit dem mindestens einen Signal des anderen Energiezählers, wobei der Korrelationswert erhalten wird, und
dadurch wird der Korrelationswert bestimmt, ob der nachfolgende Energiezähler an denselben Zweig angeschlossen ist, der von der genannten Einspeisung und Phase des Leistungstransformators gespeist wird, an dem der andere Energiezähler als angeschlossen ermittelt wurde.

8. Verfahren nach dem vorhergehenden Anspruch, wobei die Korrelation des mindestens einen Signals von dem Energiezähler mit einer Vielzahl von Signalen von einer Vielzahl von anderen Energiezählern durchgeführt wird und der Korrelationswert von dem anderen Energiezähler erhalten wird, der die höchste Korrelation mit dem mindestens einen Signal von dem Energiezähler bereitstellt.

9. Verfahren nach einem der vorhergehenden Ansprüche, wobei das mindestens eine Signal von einem Leistungstransformator und das mindestens eine Signal von einem Energiezähler aus Spannungssignalen bestehen.

10. Verfahren nach einem der vorhergehenden Ansprüche, wobei die Abtastfrequenz jedes der Signale im Bereich von 3-20 Minuten, vorzugsweise 5-15, besonders bevorzugt 15 Minuten, liegt.

11. Ein Vorrichtung zur autonomen Abbildung eines Energiezählers, die so konfiguriert ist, dass sie das Verfahren nach einem der Ansprüche 1-10 implementiert, wobei die Vorrichtung Mittel zur Gewinnung mindestens eines Signals von einem Leistungstransformator (110) und zur Gewinnung mindestens eines Signals von einem Energiezähler umfasst.

12. Ein System für die Vorrichtung zur autonomen Abbildung eines Energiezählers, wobei es ferner die Vorrichtung nach dem vorhergehenden Anspruch und den genannten Energiezähler umfasst, wobei der Energiezähler so konfiguriert ist, dass er das mindestens eine Signal an die Vorrichtung fernüberträgt.

13. System nach dem vorhergehenden Anspruch, wobei es ferner einen Leistungstransformator-Sensor umfasst, der so konfiguriert ist, dass er das mindestens eine Signal von einem Leistungstransformator bezieht, wobei der Leistungstransformator-Sensor so konfiguriert ist, dass er das mindestens eine Signal an die Vorrichtung fernüberträgt.

14. System nach dem vorhergehenden Anspruch, wobei das System eine Vielzahl von Leistungstransformator-Sensoren und Energiezählern umfasst.

15. Nicht-transitorisch Speichermedien mit Programmanweisungen, die zur Durchführung des Verfahrens nach einem der Ansprüche 1-10 ausgeführt werden können.

## Revendications

1. Procédé de cartographie autonome d'un compteur d'énergie comprenant les étapes suivantes :
i) obtenir au moins un signal provenant d'un transformateur de puissance (110),
ii) obtenir au moins un signal provenant d'un compteur d'énergie (120),
iii) mettre en corrélation l'au moins un signal provenant du transformateur de puissance avec l'au moins un signal provenant d'un compteur d'énergie, obtenant ainsi une valeur de corrélation (130),
iv) sur la base de la valeur de corrélation, déterminer si ledit compteur d'énergie est connecté à une branche alimentée par ledit transformateur de puissance (140), et
**caractérisé en ce que** l'au moins un signal provenant d'un transformateur de puissance comprend un signal obtenu à partir d'un départ du transformateur de puissance, et l'étape iv) (140) permet de déterminer si ledit compteur d'énergie est connecté à une branche alimentée par ledit départ du transformateur de puissance, et dans lequel la corrélation de l'étape iii) (130) comprend spécifiquement :
- déterminer une charge dudit transformateur et associer logiquement plus d'un compteur d'énergie à ladite charge,
- faire la somme des signaux provenant de ces plusieurs compteurs d'énergie, et
- faire correspondre logiquement ladite somme à la charge du transformateur, la valeur de corrélation étant obtenue à partir de cette correspondance.

2. Procédé selon la revendication précédente, dans lequel l'au moins un signal provenant d'un transformateur de puissance comprend en outre un signal obtenu à partir d'une phase de ce transformateur de puissance, dans lequel l'étape iv) (140) permet de déterminer si ledit compteur d'énergie est connecté à une branche alimentée par cette phase et par ledit départ du transformateur de puissance.

3. Procédé selon l'une quelconque des revendications précédentes, dans lequel chaque signal provenant de chaque compteur d'énergie comprend des données de séries de puissance active provenant de ce compteur.

4. Procédé selon la revendication précédente, dans lequel la détermination d'une charge comprend spécifiquement la détermination des données de séries de puissance active du transformateur, la corrélation des données de séries de puissance active du transformateur de puissance avec les données de séries de puissance active de plusieurs compteurs d'énergie.

5. Procédé selon la revendication précédente, dans lequel ladite correspondance est effectuée à un niveau monophasique, et ensuite à un niveau triphasique.

6. Procédé selon l'une quelconque des revendications 2 à 5, dans lequel ladite corrélation de l'étape iii) (130) comprend spécifiquement aussi une corrélation entre trois signaux correspondant à chaque phase et l'au moins un signal provenant d'un compteur d'énergie, l'étape iv) (140) permettant de déterminer si ledit compteur d'énergie est connecté à une branche alimentée par ladite phase du transformateur de puissance.

7. Procédé selon l'une quelconque des revendications 2 à 5 et la revendication 6, lequel comprend aussi, en déterminant la branche alimentée par un départ et la branche alimentée par une phase du transformateur de puissance à laquelle un compteur d'énergie ultérieur est connecté, et en déterminant que ce compteur d'énergie ultérieur a des données de séries de puissance active nulles :
- associer logiquement ce compteur d'énergie à au moins un autre compteur d'énergie dont il a été déterminé qu'il était connecté à une même branche alimentée par un départ et une phase du transformateur de puissance, et
- mettre en corrélation l'au moins un signal du compteur d'énergie ultérieur avec l'au moins un signal de l'autre compteur d'énergie, en obtenant la valeur de corrélation, et
déterminer ainsi la valeur de corrélation, à savoir si ledit compteur d'énergie ultérieur est connecté à la même branche alimentée par ledit départ et ladite phase du transformateur de puissance, à laquelle il a été déterminé que l'autre compteur d'énergie était connecté.

8. Procédé selon la revendication précédente, dans lequel la corrélation du au moins un signal du compteur d'énergie est effectuée avec une pluralité de signaux provenant d'une pluralité d'autres compteurs d'énergie, et la valeur de corrélation est obtenue à partir de l'autre compteur d'énergie présentant la corrélation la plus élevée avec l'au moins un signal du compteur d'énergie.

9. Procédé selon l'une quelconque des revendications précédentes, dans lequel ledit au moins un signal provenant d'un transformateur de puissance et ledit au moins un signal provenant d'un compteur d'énergie sont des signaux de tension.

10. Procédé selon l'une quelconque des revendications précédentes, dans lequel la fréquence d'échantillonnage de chacun desdits signaux est comprise entre 3 et 20 minutes, préférablement entre 5 et 15 minutes, et encore plus préférablement de 15 minutes.

11. Dispositif pour la cartographie autonome d'un compteur d'énergie, lequel est configuré pour mettre en oeuvre le procédé de l'une quelconque des revendications 1 à 10, le dispositif comprenant des moyens pour obtenir au moins un signal provenant d'un transformateur de puissance (110) et pour obtenir au moins un signal provenant d'un compteur d'énergie.

12. Système pour le dispositif pour la cartographie autonome d'un compteur d'énergie, lequel comprend en outre le dispositif selon la revendication précédente et le compteur d'énergie référencé, le compteur d'énergie étant configuré pour transmettre à distance ledit au moins un signal au dispositif.

13. Système selon la revendication précédente, lequel comprend en outre un capteur de transformateur de puissance configuré pour acquérir ledit au moins un signal provenant d'un transformateur de puissance, le capteur du transformateur de puissance étant configuré pour transmettre à distance ledit au moins un signal au dispositif.

14. Système selon la revendication précédente, où le système comprend une pluralité de capteurs de transformateurs de puissance et de compteurs d'énergie.

15. Support de stockage non transitoire comprenant des instructions de programme exécutables pour mettre en oeuvre le procédé de l'une quelconque des revendications 1 à 10.
